# FASCICULE DE BREVET EUROPEEN

(11) **EP 3 201 951 B1**
(45) Date de publication et mention de la délivrance du brevet: **27.11.2019**
(21) Numéro de dépôt: 15788111.1
(22) Date de dépôt: 29.09.2015
(51) Int. Cl.: H01L 33/06, H01L 33/18, H01L 33/22, H01L 33/24

(54) **DISPOSITIF OPTOELECTRONIQUE A ELEMENTS SEMICONDUCTEURS TRIDIMENSIONNELS**
OPTOELEKTRONISCHE VORRICHTUNG MIT DREIDIMENSIONALEN HALBLEITERELEMENTEN
OPTOELECTRONIC DEVICE WITH THREE-DIMENSIONAL SEMICONDUCTOR ELEMENTS

(30) Priorité: 30.09.2014 FR 1459275
(43) Date de publication de la demande: 09.08.2017
(73) Titulaire: Commissariat à l'Energie Atomique et aux Energies Alternatives, 75015 Paris (FR); Aledia, 38040 Grenoble (FR)
(72) Inventeur: ROBIN, Ivan-Christophe, F-38000 Grenoble (FR); DUSSAIGNE, Amélie, F-38690 Bizonnes (FR); FEUILLET, Guy, F-38410 Saint Martin D'uriage (FR); GAUGIRAN, Stéphanie, F-38100 Grenoble (FR)
(74) Mandataire: Cabinet Beaumont
(86) Numéro de dépôt international: PCT/FR2015/052602
(87) Numéro de publication internationale: WO 2016/051078

(56) Documents cités:
- EP-A1- 2 333 847
- EP-A1- 2 333 847
- US-A1- 2010 006 817
- US-A1- 2012 205 613

## Description

La présente demande de brevet revendique la priorité de la demande de brevet français FR14/59275.

### Domaine

La présente invention concerne de façon générale les dispositifs optoélectroniques à base de matériaux semiconducteurs et leurs procédés de fabrication.

Par dispositifs optoélectroniques, on entend des dispositifs adaptés à effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés à des applications photovoltaïques.

### Exposé de l'art antérieur

On s'intéresse plus particulièrement ici à des dispositifs optoélectroniques de type radiaux comprenant des éléments semiconducteurs tridimensionnels et une zone active formée à la périphérie de chaque élément tridimensionnel. On appelle zone active du dispositif optoélectronique la région depuis laquelle est émise la majorité du rayonnement électromagnétique fourni par le dispositif optoélectronique ou est captée la majorité du rayonnement électromagnétique reçu par le dispositif optoélectronique.

Des exemples d'éléments tridimensionnels sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI. De tels dispositifs sont, par exemple, décrits dans les demandes de brevet français FR 2 995 729 et FR 2 997 558, ainsi que dans la demande de brevet EP 2 333 847 A1.

Les éléments tridimensionnels, notamment des microfils ou nanofils semiconducteurs, sont généralement formés sur un substrat et chaque élément tridimensionnel est au moins partiellement recouvert d'une structure semiconductrice comprenant une zone active adaptée à émettre ou à capter un rayonnement électromagnétique. Il est connu de réaliser une zone active comprenant un puits quantique unique ou des puits quantiques multiples. Un puits quantique unique est réalisé en interposant, entre deux couches d'un premier matériau semiconducteur, par exemple un composé III-V, notamment du GaN, respectivement dopé de type P et N, une couche d'un deuxième matériau semiconducteur, par exemple un alliage du composé III-V ou II-VI et d'un troisième élément, notamment le InGaN, dont la bande interdite est différente du premier matériau dopé. Une structure de puits quantiques multiples comprend un empilement de couches semiconductrices formant une alternance de puits quantiques et de couches barrières.

La longueur d'onde du rayonnement électromagnétique émis ou capté par le dispositif optoélectronique dépend notamment de la bande interdite du deuxième matériau formant le puits quantique. Lorsque le deuxième matériau est un alliage du composé III-V ou II-VI et d'un troisième élément, par exemple le InGaN, la longueur d'onde du rayonnement émis ou capté dépend notamment du pourcentage atomique du troisième élément, par exemple l'indium. En particulier, plus le pourcentage atomique d'indium est élevé, plus la longueur d'onde est élevée.

Un inconvénient est que lorsque le pourcentage atomique d'indium dépasse un seuil, il est observé des différences de paramètres de mailles entre les couches de GaN et de InGaN du puits quantique qui peuvent entraîner la formation de défauts non radiatifs dans la zone active, tels que des dislocations, ce qui entraîne une diminution importante du rendement quantique de la zone active du dispositif optoélectronique. Il existe donc une longueur d'onde maximale du rayonnement émis ou capté par un dispositif optoélectronique dont la zone active comprend un puits quantique unique ou des puits quantiques multiples à base de composés III-V ou II-VI.

Toutefois, l'utilisation de matériaux à base de composés III-V ou II-VI est souhaitable dans la mesure où il existe des procédés de croissance par épitaxie de tels matériaux sur des substrats de grandes dimensions et à coût réduit.

### Résumé

Parmi les modes de réalisation décrit ci-après seuls ceux rentrant dans l'objet des revendications font partie de l'invention. Ainsi, un objet d'un mode de réalisation est de pallier au moins en partie les inconvénients des dispositifs optoélectroniques décrits précédemment et de leurs procédés de fabrication.

Un autre objet d'un mode de réalisation est d'augmenter la longueur d'onde du rayonnement électromagnétique pouvant être émis ou capté par le dispositif optoélectronique.

Un autre objet d'un mode de réalisation est que la zone active du dispositif optoélectronique comprend un empilement de couches de matériaux semiconducteurs à base de composés III-V ou II-VI.

Un autre objet d'un mode de réalisation est de commander la longueur d'onde du rayonnement électromagnétique pouvant être émis ou capté par le dispositif optoélectronique.

Ainsi, un mode de réalisation prévoit un dispositif optoélectronique comprenant des éléments semiconducteurs tridimensionnels majoritairement en un premier composé choisi parmi le groupe comprenant les composés III-V, les composés II-VI et les composés IV, chaque élément semiconducteur délimitant, éventuellement avec des portions isolantes recouvrant partiellement ledit élément semiconducteur, au moins une première surface comprenant des facettes jointives inclinées les unes par rapport aux autres, le dispositif optoélectronique comprenant des boîtes quantiques à au moins certaines des jointures entre les facettes, les boîtes quantiques étant majoritairement en un mélange du premier composé et d'un élément supplémentaire et étant adaptées à l'émission ou à la réception d'un premier rayonnement électromagnétique à une première longueur d'onde.

Selon un mode de réalisation, le dispositif comprend, en outre, une couche active comprenant au moins un puits quantique unique ou des puits quantiques multiples et adaptée à l'émission ou à la réception d'un deuxième rayonnement électromagnétique à une deuxième longueur d'onde différente de la première longueur d'onde.

Selon un mode de réalisation, le dispositif comprend, en outre, une deuxième surface, distincte de la première surface, ladite couche active recouvrant la deuxième surface.

Selon un mode de réalisation, la couche active recouvre les boîtes quantiques.

Selon un mode de réalisation, chaque boîte quantique est majoritairement en un composé InₓAl_{y}Ga_{1-x-y}N où 0≤x≤1, 0≤y≤1 et 1-x-y>0.

Selon un mode de réalisation, les éléments semiconducteurs sont des nanofils, des microfils et/ou des structures pyramidales de taille nanométrique ou micrométrique.

Selon un mode de réalisation, les éléments semiconducteurs ont une forme allongée selon une direction privilégiée, et la distance, mesurée perpendiculairement à la direction privilégiée, entre deux jointures de paires de jointures adjacentes est supérieure à 5 nm.

Selon un mode de réalisation, la distance, mesurée parallèlement à la direction privilégie, entre deux jointures adjacentes est inférieure à 1 µm.

Selon un mode de réalisation, la densité de jointures est supérieure à 10⁸ jointures/cm².

Un autre mode de réalisation prévoit également un procédé de fabrication d'un dispositif optoélectronique comprenant les étapes suivantes :
formation d'éléments semiconducteurs tridimensionnels majoritairement en un premier composé choisi parmi le groupe comprenant les composés III-V, les composés II-VI et les composés IV, chaque élément semiconducteur délimitant, éventuellement avec des portions isolantes recouvrant partiellement ledit élément semiconducteur, au moins une première surface comprenant des facettes jointives inclinées les unes par rapport aux autres ; et
formation de boîtes quantiques à au moins certaines des jointures entre les facettes, les boîtes quantiques étant majoritairement en un mélange du premier composé et d'un élément supplémentaire et étant adaptées à l'émission ou à la réception d'un premier rayonnement électromagnétique à une première longueur d'onde.

Selon un mode de réalisation, le procédé comprend, en outre, la formation d'une couche active comprenant au moins un puits quantique unique ou des puits quantiques multiples et adaptée à l'émission ou à la réception d'un deuxième rayonnement électromagnétique à une deuxième longueur d'onde différente de la première longueur d'onde.

Selon un mode de réalisation, le procédé comprend, en outre, la formation des éléments semiconducteurs et la gravure partielle des éléments semiconducteurs pour former la première surface.

Selon un mode de réalisation, la première surface est formée simultanément à la croissance des éléments semiconducteurs.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est une coupe, partielle et schématique, d'un exemple de dispositif optoélectronique à microfils ou nanofils ;
la figure 2 est une coupe, partielle et schématique, d'un mode de réalisation d'un dispositif optoélectronique à microfils ou nanofils ;
les figures 3 et 4 sont des vues agrandies, partielles et schématiques, illustrant un mode de réalisation d'une zone active comprenant des boîtes quantiques ;
les figures 5 à 9 sont des coupes, partielles et schématiques, de modes de réalisation de dispositifs optoélectroniques à microfils ou nanofils ; et
les figures 10 à 13 sont des coupes, partielles et schématiques, de structures obtenues à une étape intermédiaire de la fabrication de modes de réalisation de dispositifs optoélectroniques à microfils ou nanofils.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits. Dans la suite de la description, sauf indication contraire, les termes "sensiblement", "environ" et "de l'ordre de" signifient "à 10 % près".

La présente description concerne des dispositifs optoélectroniques comprenant des éléments semiconducteurs ayant la forme de microfils, de nanofils ou de pyramides.

Le terme "microfil" ou "nanofil" désigne une structure tridimensionnelle de forme allongée, par exemple cylindrique, conique ou tronconique, selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil. La base du fil a, par exemple, une forme ovale, circulaire ou polygonale, notamment triangulaire, rectangulaire, carrée ou hexagonale.

Dans la suite de la description, le terme pyramide ou pyramide tronquée désigne une structure tridimensionnelle de forme pyramidale. Cette structure pyramidale peut être tronquée, c'est-à-dire que le haut du cône est absent, laissant place à un plateau. La base de la pyramide est inscrite dans un polygone dont la dimension des côtés est de 100 nm à 10 µm, préférentiellement entre 1 et 3 µm. Le polygone formant la base de la pyramide peut être un hexagone. La hauteur de la pyramide entre la base de la pyramide et le sommet ou le plateau sommital varie de 100 nm à 20 µm, préférentiellement entre 1 µm et 10 µm.

Dans la suite de la description, des modes de réalisation vont être décrits dans le cas d'un dispositif optoélectronique à diodes électroluminescentes. Toutefois, il est clair que ces modes de réalisation peuvent concerner d'autres applications, notamment des dispositifs dédiés à la détection ou la mesure d'un rayonnement électromagnétique ou des dispositifs dédiés aux applications photovoltaïques.

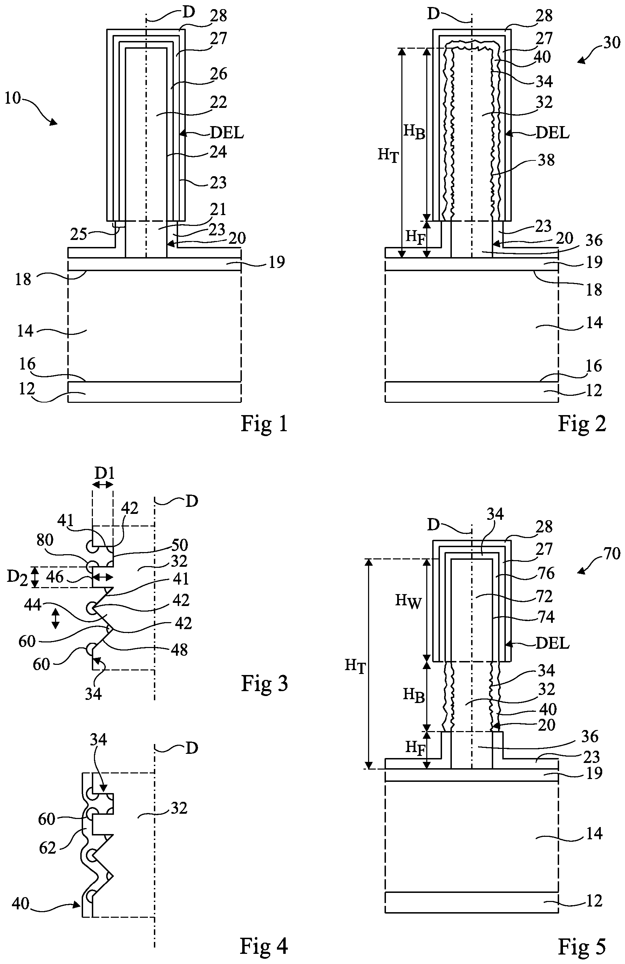

La figure 1 est une coupe, partielle et schématique, d'un dispositif optoélectronique 10 réalisé à partir de fils tels que décrits précédemment et adapté à émettre un rayonnement électromagnétique.

Le dispositif 10 comprend, du bas vers le haut en figure 1 :
une première électrode de polarisation 12 ;
un substrat 14, par exemple semiconducteur, comprenant des faces parallèles 16 et 18, la face 16 étant au contact de l'électrode 12 ;
une couche de nucléation 19 recouvrant la face 18 ;
des éléments semiconducteurs 20, qui dans le présent mode de réalisation correspondent à des fils, un seul fil 20 d'axe D étant représenté, chaque fil 20 comprenant une portion inférieure 21, en contact avec la couche de nucléation 19, se prolongeant par une portion supérieure 22 ;
une couche isolante 23 recouvrant la couche de nucléation 19 et la périphérie de la portion inférieure 21 de chaque fil 20 ;
une coque 25 recouvrant la paroi extérieure 24 de la portion supérieure 22 de chaque fil 20, la coque 25 comprenant au moins un empilement d'une zone active 26 recouvrant la portion supérieure 22 et d'une couche semiconductrice 27 recouvrant la zone active 26 ; et
une couche de seconde électrode 28 recouvrant chaque coque 25.

L'ensemble formé par un fil 20 et la coque 25 constitue une diode électroluminescente DEL. Lorsque plusieurs diodes électroluminescentes DEL sont formées sur le substrat 14, elles peuvent être connectées en série et/ou en parallèle et former un ensemble de diodes électroluminescentes. L'ensemble peut comprendre de quelques diodes électroluminescentes DEL à un millier de diodes électroluminescentes DEL.

La zone active 26 est la région depuis laquelle est émise la majorité du rayonnement fourni par le dispositif 10. La zone active 26 peut comporter des moyens de confinement. A titre d'exemple, la zone 26 peut comprendre un puits quantique unique. Elle comprend alors un matériau semiconducteur différent du matériau semiconducteur formant la portion supérieure 22 et la couche 27 et ayant une bande interdite inférieure à celle du matériau formant la portion supérieure 22 et la couche 27. La zone active 26 peut comprendre des puits quantiques multiples. Elle comprend alors un empilement de couches semiconductrices formant une alternance de puits quantiques et de couches barrières.

La paroi externe 24 des fils 20 correspond généralement à des plans cristallins sensiblement lisses. La zone active 26, ayant une structure monocouche ou multicouche, est généralement réalisée par une ou plusieurs étapes de dépôt par épitaxie sur la paroi extérieure 24.

Le dispositif 10 décrit en figure 1 fonctionne convenablement mais présente divers inconvénients. En effet, la longueur d'onde du rayonnement émis par la zone active 26 dépend du matériau utilisé pour réaliser le puits quantique unique ou les puits quantiques multiples. Par exemple, dans le cas où la zone active 26 comprend un alliage du type InGaN, la longueur d'onde du rayonnement émis dépend notamment de la proportion d'indium. Toutefois, le rendement quantique interne de la zone active 26 chute lorsque la proportion atomique d'indium dépasse 16 %, ce qui correspond à une longueur d'onde d'émission de 460 nm.

Les inventeurs ont mis en évidence que lorsque la paroi extérieure 24 du fil 20 n'est pas lisse mais comprend des facettes inclinées les unes par rapport aux autres, des boîtes quantiques (en anglais quantum dots) peuvent être formées au niveau de jointures entre les facettes. Une boîte quantique est une structure semiconductrice de dimension nanométrique. Elle se comporte comme un puits de potentiel qui confine les électrons et les trous dans les trois dimensions de l'espace, dans une région d'une taille de l'ordre de la longueur d'onde des électrons, soit quelques dizaines de nanomètres dans un semiconducteur. Il s'agit donc d'une structure différente d'un puits quantique qui confine les électrons et les trous dans une seule direction. Les inventeurs ont mis en évidence que les boîtes quantiques peuvent permettre l'émission d'un rayonnement à une longueur d'onde différente, et en particulier plus élevée, que la longueur d'onde du rayonnement émis par un puits quantique.

La figure 2 est une vue en coupe, partielle et schématique, d'un mode de réalisation d'un dispositif optoélectronique 30. Le dispositif optoélectronique 30 comprend les mêmes éléments que le dispositif optoélectronique 10 représenté en figure 1 à la différence que la portion supérieure 22 est remplacée par une portion 32 de fil ayant une paroi latérale extérieure 34 irrégulière ou rugueuse, c'est-à-dire qui présente des aspérités. La portion inférieure 21 de chaque fil 20 peut, en outre, également être remplacée par une portion 36 ayant une paroi latérale extérieure éventuellement rugueuse. On appelle H_{T} la hauteur totale du fil 20, H_{B} la hauteur de la portion 32 de fil dont la paroi extérieure 34 est rugueuse et H_{F} la hauteur de la portion inférieure 36. La zone active 26 du dispositif 10 est, en outre, remplacée par une zone active 40 formée sur la paroi rugueuse 34. La zone active 40 comprend des boîtes quantiques.

Les éléments semiconducteurs 20 sont, au moins en partie, formés à partir d'au moins un matériau semiconducteur. Le matériau semiconducteur est choisi parmi le groupe comprenant les composés III-V, les composés II-VI ou les semiconducteurs ou composés du groupe IV.

Les éléments semiconducteurs 20 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les éléments semiconducteurs 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les éléments semiconducteurs 20 peuvent être, au moins en partie, formés à partir de matériaux semiconducteurs comportant majoritairement au moins un élément du groupe IV. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

Les éléments semiconducteurs 20 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

Lorsque les éléments semiconducteurs tridimensionnels 20 du dispositif optoélectronique correspondent à des fils, la hauteur H_{T} peut être comprise entre 250 nm et 50 µm. Chaque fil 20 peut avoir une structure semiconductrice allongée selon un axe sensiblement perpendiculaire à la face 18. Chaque fil 20 peut avoir une forme générale cylindrique, dont la base a, par exemple, une forme ovale, circulaire ou polygonale, notamment triangulaire, rectangulaire, carrée ou hexagonale. Les axes de deux fils 20 adjacents peuvent être distants de 0,5 µm à 10 µm et de préférence de 1,5 µm à 5 µm. A titre d'exemple, les fils 20 peuvent être régulièrement répartis, notamment selon un réseau hexagonal.

Selon un mode de réalisation, la portion inférieure 36 de chaque fil est principalement constituée d'un composé III-N, par exemple du nitrure de gallium, dopé d'un premier type de conductivité, par exemple de type N. Le dopant de type N peut être le silicium. La hauteur H_{F} de la portion inférieure 21 peut être comprise entre 500 nm et 25 µm.

Selon un mode de réalisation, la portion 32 de chaque fil est, par exemple, au moins partiellement réalisée dans un composé III-N, par exemple du nitrure de gallium. La portion 32 peut être dopée du premier type de conductivité, par exemple de type N, ou ne pas être dopée de façon intentionnelle. La hauteur H_{B} de la portion 32 peut être comprise entre 500 nm et 25 µm.

A titre de variante, pour chaque fil 20, la couche isolante 23 peut s'étendre sur une partie de la portion 32, ne pas s'étendre sur la totalité de la portion inférieure 36 ou s'étendre sur une partie de la zone active 40.

Lorsque les éléments semiconducteurs tridimensionnels 20 du dispositif optoélectronique 10 correspondent à des pyramides, la hauteur de chaque pyramide peut être comprise entre 100 nm et 25 µm. Chaque pyramide peut avoir une structure semiconductrice allongée selon un axe sensiblement perpendiculaire à la face 18. La base de chaque pyramide peut avoir une forme générale de type ovale, circulaire ou polygonale, notamment triangulaire, rectangulaire, carrée ou hexagonale. Les centres de deux pyramides adjacentes peuvent être distants de 0,25 µm à 10 µm et de préférence de 1,5 µm à 5 µm. A titre d'exemple, les pyramides peuvent être régulièrement réparties, notamment selon un réseau hexagonal.

Dans le cas d'un fil 20 composé principalement de GaN, la structure cristalline du fil peut être du type wurtzite, le fil s'étendant selon la direction cristallographique c.

Pour chaque élément semiconducteur 20, la zone active 40 comprend des boîtes quantiques d'un matériau comportant majoritairement un composé III-V, un composé II-VI ou un composé IV dans lequel est incorporé un élément supplémentaire.

La figure 3 est une vue agrandie, partielle et schématique, d'un mode de réalisation de la paroi latérale rugueuse 34 de la portion 32 du fil à une première étape d'un mode de réalisation d'un procédé de fabrication de la zone active 40. La paroi 34 comprend une succession de facettes 41 jointives qui sont reliées les unes aux autres par des jointures, correspondant à des coins ou à des arêtes 42. Les coins ou les arêtes 42 peuvent être en "relief" ou en "creux". A titre d'exemple, un coin en "relief" peut correspondre au sommet d'une aspérité 44 et une arête 42 en "relief" peut correspondre au bord d'un plateau 46 en relief. Un coin 42 en "creux" peut correspondre au fond d'un évidement 48. Une arête 42 en "creux" peut correspondre au bord d'un plateau 50 en creux.

Selon un autre mode de réalisation, des portions isolantes recouvrent partiellement la portion 32 du fil 20 et exposent des zones de la portion 32 du fil 20. La paroi rugueuse 34 est alors formée par la portion 32 du fil 20 recouverte des portions isolantes. Les facettes appartiennent alors à la portion 32 du fil ou à des portions isolantes et les jointures correspondent notamment aux bords des zones exposées de la portion 32 du fil 20.

Les inventeurs ont mis en évidence que, lorsque la rugosité de la paroi 34 a des propriétés particulières et lorsque les mêmes conditions de croissance par épitaxie que celles des puits quantiques de la zone active 26 du dispositif 10 sont mises en oeuvre en présence de la paroi rugueuse 34, il y a formation dans un premier temps de boîtes quantiques 60 au niveau des arêtes ou coins 42 en creux, et éventuellement au niveau des arêtes ou coins 42 en relief. Ces arêtes ou coins 42 forment alors des sites de croissance de boîtes quantiques 60.

Une explication serait que lorsque des atomes sont déposés sur la paroi 34 lors de la croissance épitaxiale, ils tendent à s'accumuler au niveau des jointures 42 pour former les boîtes quantiques 60. Le mécanisme de formation des boîtes quantiques 60 est différent de la méthode dite de Stranski-Krastanov qui est mise en oeuvre sur des parois lisses. Les jointures 42 forment des sites de croissance des boîtes quantiques.

Selon un mode de réalisation, la longueur d'une jointure 42 est de préférence comprise entre 1 monocouche, par exemple de l'ordre de 0,259 nm pour le GaN, et 20 monocouches, par exemple de l'ordre de 5 nm.

Selon un mode de réalisation, la distance D1, mesurée perpendiculairement à l'axe D, entre deux jointures 42 adjacentes est supérieure à 5 nm. Ceci permet d'éviter que des atomes ayant atteint une jointure 42 ne s'en échappent. En effet, la vitesse de diffusion d'un atome sur une facette 41 qui n'est pas parallèle à l'axe D est généralement plus faible que la vitesse de diffusion d'un atome sur une facette 41 parallèle à l'axe D.

Selon un mode de réalisation, la distance D2, mesurée parallèlement à l'axe D, entre deux jointures 42 adjacentes est inférieure à 1 µm. Ceci permet à un atome ayant atteint une facette 41 parallèle à l'axe D de pouvoir diffuser jusqu'à une jointure 42.

Le nombre d'arêtes ou de coins 42 dépend de la répartition souhaitée des boîtes quantiques 60. Selon un mode de réalisation, les jointures 42 peuvent être réparties de façon sensiblement homogène si une répartition sensiblement homogène des boîtes quantiques 60 est recherchée. En fonctionnement, chaque boîte quantique 60 peut émettre ou recevoir un rayonnement électromagnétique. Dans le cas de l'émission d'un rayonnement lumineux, pour obtenir une émission lumineuse qui est perçue par un observateur de façon sensiblement continue et homogène, la densité de jointures 42 est supérieure à 10⁸ jointures/cm².

La figure 4 représente la structure obtenue à une deuxième étape d'un mode de réalisation d'un procédé de fabrication de la zone active 40 après avoir maintenu les mêmes conditions de croissance par épitaxie que celles qui ont, à la première étape, entraîné la formation des boîtes quantiques 60. Une couche 62 sensiblement continue peut se former et relier les boîtes quantiques 60. La couche 62 peut avoir sensiblement la même composition et les mêmes propriétés que la zone active 26 comprenant un puits quantique unique.

Selon un mode de réalisation, le procédé de fabrication de la zone active 40 peut être interrompu après la première étape. La zone active 40 ne comprend alors sensiblement que les boîtes quantiques 60. La zone active 40 peut être recouverte par la couche semiconductrice 27 qui peut être en contact avec les boîtes quantiques 60 et avec la portion 32 du fil 20. Selon un autre mode de réalisation, le procédé de fabrication de la zone active 40 comprend les première et deuxième étapes décrites précédemment. La zone active 40 comprend alors les boîtes quantiques 60 et la couche active 62. La couche semiconductrice 27 qui peut recouvrir la zone active 40 n'est alors pas en contact direct avec la portion 32 du fil 20.

Dans des mêmes conditions de croissance, la composition d'une boîte quantique 60 est différente de la composition d'un puits quantique. De ce fait, la longueur d'onde du rayonnement fourni ou capté par les boîtes quantiques 60 est différente de la longueur d'onde du rayonnement fourni par un puits quantique réalisé dans les mêmes conditions.

A titre d'exemple, dans le cas de InGaN, la proportion d'indium incorporé dans une boîte quantique 60 peut être supérieure à la proportion d'indium pouvant être incorporé dans un puits quantique réalisé dans les mêmes conditions. De ce fait, la longueur d'onde du rayonnement fourni par une boîte quantique 60 peut être supérieure à la longueur d'onde du rayonnement fourni par un puits quantique réalisé dans les mêmes conditions. A titre d'exemple, la longueur d'onde du rayonnement émis par un puits quantique unique en InGaN avec une proportion atomique d'indium de 16 % est d'environ 460 nm et la longueur d'onde du rayonnement émis par des boîtes quantiques en InGaN formées dans les mêmes conditions est d'environ 475 nm.

Selon un mode de réalisation, le dispositif optoélectronique 30 comprend des boîtes quantiques 60 dans lesquelles la proportion atomique de l'élément supplémentaire par rapport au composé III-V ou II-VI est supérieure strictement à la proportion de cet élément dans un puits quantique formé dans les mêmes conditions. A titre d'exemple, dans le cas de boîtes quantiques d'InGaN, la proportion atomique d'indium est supérieure à 15 %, de préférence supérieure à 20 %, plus préférentiellement supérieure à 25 %. A titre d'exemple, dans le cas de boîtes quantiques d'InGaAs, la proportion atomique d'indium est supérieure à 40 %, de préférence supérieure à 45 %, plus préférentiellement supérieure à 50 %.

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V, tel que du GaN ou du GaAs, ou un substrat en ZnO. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator).

Le substrat 14 peut être fortement dopé, faiblement dopé ou non dopé. Dans le cas où le substrat est fortement dopé, le substrat semiconducteur 14 peut être dopé de façon à baisser la résistivité électrique jusqu'à une résistivité proche de celle des métaux, de préférence inférieure à quelques mohm.cm. Le substrat 14 est, par exemple, un substrat fortement dopé avec une concentration de dopants comprise entre 5*10¹⁶ atomes/cm³ et 2*10²⁰ atomes/cm³. Dans le cas où le substrat est faiblement dopé, par exemple avec une concentration de dopants inférieure ou égale à 5*10¹⁶ atomes/cm3, de préférence sensiblement égale à 10¹⁵ atomes/cm3, une région dopée du premier type de conductivité ou d'un deuxième type de conductivité, opposé au premier type, plus fortement dopée que le substrat peut être prévue qui s'étend dans le substrat 14 depuis la face 18. Dans le cas d'un substrat 14 de silicium, des exemples de dopants de type P sont le bore (B) ou l'indium (In) et des exemples de dopants de type N sont le phosphore (P), l'arsenic (As), ou l'antimoine (Sb). La face 18 du substrat 10 de silicium peut être une face (100).

L'électrode 12 peut correspondre à une couche conductrice qui s'étend sur la face 16 du substrat 14. Le matériau formant l'électrode 12 est, par exemple, du siliciure de nickel (NiSi), de l'aluminium (Al), du siliciure d'aluminium (AlSi), du titane (Ti) ou du siliciure de titane (TiSi).

La couche de germination 19 est en un matériau favorisant la croissance des éléments semiconducteurs 20. A titre d'exemple, le matériau composant la couche de germination 19 peut être un nitrure, un carbure ou un borure d'un métal de transition de la colonne IV, V ou VI du tableau périodique des éléments ou une combinaison de ces composés. A titre d'exemple, la couche de germination 19 peut être en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. La couche de germination 19 peut être dopée du même type de conductivité que le substrat 14. La couche de germination 19 a, par exemple, une épaisseur comprise entre 1 et 100 nanomètres, de préférence comprise entre 10 et 30 nanomètres.

A titre de variante, la couche de germination 19 peut être remplacée par des plots de germination reposant sur la face 18 du substrat 14, chaque fil 20 reposant sur l'un des plots de germination.

Lorsque la couche de germination 19 est en nitrure d'aluminium, elle peut être sensiblement texturée et posséder une polarité préférentielle. La texturation de la couche de germination 19 peut être obtenue par un traitement supplémentaire réalisé après le dépôt de la couche de germination. Il s'agit, par exemple, d'un recuit sous flux d'ammoniac (NH₃). Dans le cas d'un fil 20 composé principalement de GaN, la couche de germination 19 peut favoriser la croissance du GaN avec la polarité N.

La couche isolante 23 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. A titre d'exemple, l'épaisseur de la couche isolante 23 est comprise entre 5 nm et 100 nm, par exemple égale à environ 30 nm. La couche isolante 23 peut avoir une structure monocouche ou correspondre à un empilement de deux couches ou de plus de deux couches.

La couche semiconductrice 27 peut comprendre un empilement de plusieurs couches comprenant notamment :
- une couche intermédiaire de type de conductivité opposé à la portion inférieure 36 et recouvrant la zone active 40 ; et
- une couche de liaison recouvrant la couche intermédiaire et recouverte par l'électrode 28.

La couche intermédiaire, par exemple dopée de type P, peut correspondre à une couche semiconductrice ou à un empilement de couches semiconductrices et permet la formation d'une jonction P-N ou P-I-N, la zone active 40 étant comprise entre la couche intermédiaire de type P et la portion 32 de type N du fil 20 de la jonction P-N ou P-I-N.

La couche de liaison peut correspondre à une couche semiconductrice ou à un empilement de couches semiconductrices et permet la formation d'un contact ohmique entre la couche intermédiaire et l'électrode 28. A titre d'exemple, la couche de liaison peut être dopée très fortement du type opposé à la portion inférieure 36, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 28 est adaptée à polariser la zone active 40 recouvrant chaque élément semiconducteur 20 et à laisser passer le rayonnement électromagnétique émis par les diodes électroluminescentes DEL. Le matériau formant l'électrode 28 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 28 a une épaisseur comprise entre 5 nm et 200 nm, de préférence entre 20 nm et 50 nm.

Lorsqu'une tension est appliquée entre les électrodes 12 et 28, un rayonnement lumineux est émis par la zone active 40. Lorsque la zone active 40 a la structure représentée en figure 3 et ne comprend que des boîtes quantiques 60, le rayonnement émis est sensiblement monochromatique. Lorsque la zone active 40 a la structure représentée en figure 4 et comprend les boîtes quantiques 60 et la couche active 62, la longueur d'onde du rayonnement émis par les boîtes quantiques 60 est différente du rayonnement émis par la couche active 62 et la diode électroluminescente DEL du dispositif optoélectronique 30 peut émettre un rayonnement à deux longueurs d'onde différentes.

On peut ainsi obtenir un dispositif ayant des propriétés d'émission ou de réception large bande. En particulier, le spectre d'émission ou de réception obtenu peut être caractéristique d'une lumière blanche.

La figure 5 est une vue en coupe d'un autre mode de réalisation d'un dispositif optoélectronique 70. Le dispositif 70 comprend l'ensemble des éléments du dispositif optoélectronique 30 représenté en figure 2 à la différence que la portion 32 de fil à paroi latérale 34 rugueuse se prolonge par une portion 72 de fil à paroi latérale 74 lisse qui peut avoir la même structure que la portion 22 du dispositif optoélectronique 10 représenté en figure 1. La portion 72 a une hauteur H_{W} comprise entre 10 nm et 10 µm. La portion 72 est recouverte d'une couche active 76 qui peut avoir la même structure et la même composition que la zone active 26 du dispositif optoélectronique 10 représenté en figure 1.

Dans le mode de réalisation représenté en figure 5, le rayonnement lumineux émis par la couche active 76 qui recouvre la portion 72 du fil 20 provient d'un phénomène d'électroluminescence. Le rayonnement lumineux émis par la zone active 40 qui recouvre la portion 32 du fil 20 provient d'un phénomène de photoluminescence par conversion d'une partie du rayonnement lumineux émis par la couche active 76 de fils adjacents 20. Selon un mode de réalisation, la zone active 40 peut ne pas être continue, c'est-à-dire ne pas recouvrir la paroi latérale rugueuse 34 en totalité.

Chaque diode électroluminescente DEL du dispositif optoélectronique 70 peut donc émettre à deux longueurs d'onde différentes.

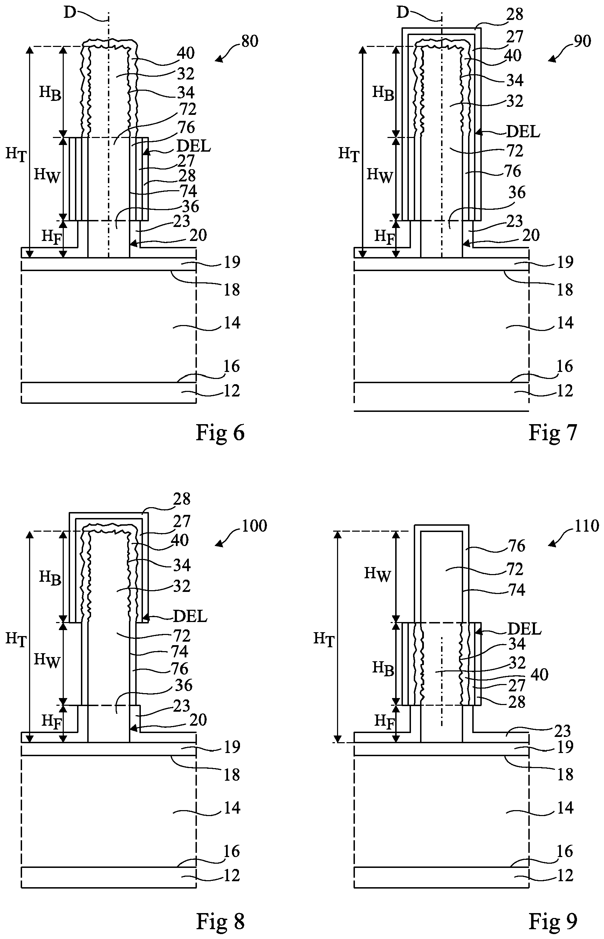

La figure 6 représente un autre mode de réalisation d'un dispositif optoélectronique 80 qui comprend l'ensemble des éléments du dispositif 70 à la différence que la portion 72 du fil 20 à paroi latérale lisse 74 est située entre la portion inférieure 36 et la portion 32 du fil 20 à paroi latérale rugueuse 34.

La figure 7 représente un autre mode de réalisation d'un dispositif optoélectronique 90 qui comprend l'ensemble des éléments du dispositif 80 représenté en figure 6 à la différence que la couche semiconductrice 27 et la couche d'électrode 28 recouvrent la portion 72 du fil 20 à paroi lisse 74 et la portion 32 du fil 20 à paroi rugueuse 34.

La figure 8 représente un autre mode de réalisation d'un dispositif optoélectronique 100 qui comprend l'ensemble des éléments du dispositif 80 représenté en figure 6 à la différence que la couche semiconductrice 27 et la couche d'électrode 28 recouvrent seulement la portion 32 du fil 20 à paroi rugueuse 34 et ne recouvrent pas la portion 72 du fil 20 à paroi lisse 74.

La figure 9 représente un autre mode de réalisation d'un dispositif optoélectronique 110 qui comprend l'ensemble des éléments du dispositif 70 représenté en figure 5 à la différence que la couche semiconductrice 27 et la couche d'électrode 28 recouvrent seulement la portion 32 du fil 20 à paroi rugueuse 34 et ne recouvrent pas la portion 72 du fil 20 à paroi lisse 74.

Les modes de réalisation représentés sur les figures 5 et 6 présentent l'avantage d'une injection du courant plus efficace avec moins de fuites. Une explication serait que la couche active est plus homogène et que les boîtes quantiques, qui convertissent une partie de la lumière émise par la couche active, émettent à plus grande longueur d'onde. Le spectre émis est alors plus large et plus stable en fonction de la tension appliquée aux diodes électroluminescentes.

Selon un mode de réalisation, la paroi rugueuse 34 est formée après la croissance de chaque fil 20 en réalisant une gravure chimique des flancs du fil 20. Les portions éventuelles du fil 20 dont les parois latérales doivent rester lisses, par exemple la portion 72 en figure 5, sont alors protégées contre la gravure, par exemple en étant recouvertes d'une couche de protection qui est retirée après l'étape de gravure.

Le procédé de croissance des fils peut être un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Déposition), les procédés hydrothermiques, la pyrolise d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphoshine (TBP), l'arsine (AsH₃), ou le diméthylhydrazine asymétrique (UDMH). On appelle rapport III/V le rapport entre le flux de gaz du précurseur de l'élément du groupe III et le flux de gaz du précurseur de l'élément du groupe V.

Selon un mode de réalisation de l'invention, dans une phase de croissance des fils du composé III-V, un précurseur d'un élément supplémentaire est ajouté en plus des précurseurs du composé III-V. La présence du précurseur de l'élément supplémentaire conduit à l'incorporation de l'élément supplémentaire dans le composé III-V pour doper ce composé III-V mais également à la formation d'une couche d'un matériau diélectrique principalement constitué de l'élément supplémentaire et de l'élément du groupe V sur les flancs latéraux des cristaux en croissance du composé III-V. L'élément supplémentaire peut être le silicium (Si). Un exemple de précurseur du silicium est le silane (SiH₄). Ceci permet de doper les fils de type N. Ceci peut entraîner, en outre, la formation d'une couche diélectrique de nitrure de silicium SiN, éventuellement sous forme stoechiométrique Si₃N₄, sur les parois latérales du fil. Le rapport entre le flux de silane et le flux de triméthylgallium, exprimés en µmol/min, est généralement compris entre 8*10⁻⁵ et 2*10⁻³, par exemple environ 4.10⁻⁴. L'épaisseur de la couche diélectrique de Si₃N₄ obtenue est alors généralement inférieure à 10 nm.

A titre d'exemple, dans le cas où la portion inférieure 36 est en GaN fortement dopée de type N, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums. Les flux de gaz indiqués précédemment sont donnés à titre indicatif et sont à adapter en fonction de la taille et des spécificités du réacteur.

Selon un mode de réalisation, la paroi rugueuse 34 est obtenue par mise en excès de dihydrogène (H₂) dans le réacteur après la croissance des fils 20. Le dihydrogène est, de façon classique, utilisé comme gaz porteur dans le réacteur mais les inventeurs ont mis en évidence qu'un excès de dihydrogène peut entraîner une gravure des parois latérales des fils et une augmentation de la rugosité de ces parois.

Selon un mode de réalisation, après la croissance des fils, le réacteur est mis sous pression de H₂, par exemple à une pression de 0,8 bar (80 KPa) pendant 5 min. On obtient la formation d'aspérités sur les parois du fil 20 exposées à la gravure.

Selon un mode de réalisation, la paroi rugueuse 34 est obtenue par une gravure partielle de la couche diélectrique recouvrant le fil 20 et qui se forme lors de la croissance du fil 20, de façon à exposer partiellement le fil 20. La gravure peut être réalisée par mise en excès de dihydrogène (H₂) dans le réacteur après la croissance des fils 20. Les zones exposées du fil forment des sites de croissance des boîtes quantiques. Selon un mode de réalisation, pour des fils en GaN dopé de type N, après la croissance des fils, le flux de triméthylgallium est interrompu alors que le flux de silane est maintenu seul, par exemple pendant 5 minutes. Le réacteur est alors mis sous pression de H₂, par exemple à une pression de 0,8 bar (80 KPa) pendant 5 min.

Selon un mode de réalisation, pour des fils en GaN dopé de type N, le rapport entre le flux de silane et le flux de triméthylgallium est augmenté. En effet, les inventeurs ont mis en évidence que le mécanisme de croissance de la couche de nitrure de silicium est modifié lorsque le silane est fortement en excès, ce qui conduit à l'obtention d'une couche de Si₃N₄ irrégulière exposant des zones du fil de GaN, formant ainsi des zones de nucléation pour les boîtes quantiques. Les zones exposées du fil de GaN forment des sites de croissance des boîtes quantiques. A titre d'exemple, le rapport entre le flux de silane et le flux de triméthylgallium, exprimés en µmol/min, est supérieur à 10⁻³.

Selon un autre mode de réalisation, pour des fils en GaN dopé de type N, le flux de silane est réduit de façon que la couche de Si₃N₄, qui se forme sur le fil, ne soit pas continue et comprend des ouvertures qui exposent des zones du fil 20, ces zones exposées formant des sites de croissance des boîtes quantiques. Dans ce but, le rapport entre le flux de silane et le flux de triméthylgallium, exprimés en µmol/min, peut être inférieur à 5*10⁻⁴.

Selon un autre mode de réalisation, la paroi 34 rugueuse est formée au fur et à mesure de la croissance de chaque fil 20.

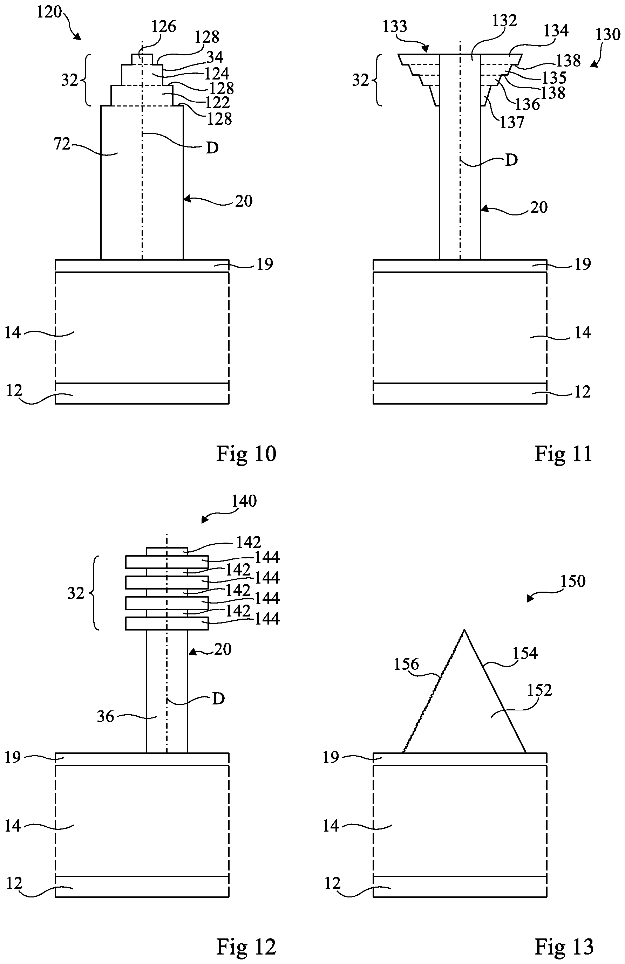

La figure 10 représente un autre mode de réalisation d'un dispositif optoélectronique 120 après l'étape de formation des fils 20 et avant l'étape de formation de la zone active 40. La portion 32 comprend une succession de parties 122, 124, 126 de sections sensiblement constantes et de diamètres différents, chaque partie étant reliée à la suivante par une marche 128, c'est-à-dire par une face sensiblement perpendiculaire à l'axe D du fil 20. Les arêtes à la jointure entre les marches 128 et les parties 122, 124, 126 forment des sites de croissance des boîtes quantiques. A titre de variante, les marches 128 peuvent être inclinées par rapport à l'axe D.

Selon un mode de réalisation du procédé de fabrication du dispositif 120, les paramètres de croissance du fil 20 sont changés selon un échelon entre deux parties 122, 124, 126 de diamètres différents. A titre d'exemple, le rapport III/V passe, selon un échelon, d'une valeur constante initiale à une valeur constante finale, entre deux parties 122, 124, 126 de diamètres différents.

La figure 11 représente un autre mode de réalisation d'un dispositif optoélectronique 130 après l'étape de formation des fils 20 et avant l'étape de formation de la zone active 40. La portion 32 comprend un coeur 132 dopé entouré d'une coque sensiblement non dopée 133 comprenant une succession de parties 134, 135, 136, 137 à parois inclinées reliées par des marches 138. Les arêtes à la jointure entre les marches 138 et les parties 134, 135, 136, 137 forment des sites de croissance des boîtes quantiques.

Selon un mode de réalisation du procédé de fabrication du dispositif 130, pour des fils en GaN dopé de type N, après la formation du coeur 132 dopé, le flux de silane est interrompu et les flux des précurseurs du gallium et de l'azote sont maintenus. La température est diminuée, par exemple de 1000°C à 750°C par paliers successifs. Ceci entraîne la formation de la coque 133 depuis le sommet du fil avec des marches 138 successives. Le diamètre de la coque 133 diminue depuis le sommet du fil 20.

La figure 12 représente un autre mode de réalisation d'un dispositif optoélectronique 140 après l'étape de formation des fils 20 et avant l'étape de formation de la zone active 40. La portion 32 du fil 20 est constituée d'une alternance de portions dopées 142, par exemple en GaN dopé de type N, et de portions non dopées 144, par exemple en GaN. Les portions non dopées 144 ont un diamètre supérieur aux portions dopées 142. Les arêtes aux jonctions entre les portions non dopées 144 et les portions dopées 142 forment des sites de croissance de boîtes quantiques.

Divers procédés peuvent être utilisés pour former des portions 144 de GaN ayant des diamètres différents de celui des portions 142 de GaN dopé. Pour cela, si on forme les portions 142 de GaN dopé avec des paramètres donnés de fonctionnement du réacteur de croissance, on modifie des paramètres de fonctionnement du réacteur pour la formation des portions 144 de GaN. Selon un mode de réalisation, la pression est modifiée et/ou la composition relative des précurseurs d'éléments du groupe III et des précurseurs d'éléments du groupe V est modifiée. Plus précisément, une diminution de la pression dans le réacteur lors de la formation d'une portion 144 de GaN par rapport à la pression utilisée pour la formation de la portion 142 de GaN dopé sous-jacente entraîne une augmentation du diamètre de la portion 144 de GaN par rapport à la portion 142 de GaN dopé sous-jacente. En outre, une augmentation du rapport V/III par rapport au rapport V/III utilisé pour la formation de la portion 142 de GaN dopé sous-jacente entraîne une augmentation du diamètre de la portion 144 de GaN par rapport à la portion 142 sous-jacente.

On note que, si la variation des paramètres est brutale, il se présente une variation brutale de diamètre. Par contre, si cette variation de paramètre est progressive, il peut exister une zone intermédiaire conique entre les portions de microfils ou de nanofils de diamètre distincts. Cette zone intermédiaire conique est constituée de plans semi-polaires.

La figure 13 représente un autre mode de réalisation d'un dispositif optoélectronique 150 après l'étape de formation des fils 20 et avant l'étape de formation de la zone active 40. Dans ce mode de réalisation, chaque élément semiconducteur correspond à une pyramide 152. Les inventeurs ont mis en évidence que pour certaines conditions de croissance des pyramides 152, certains flancs des pyramides sont plus rugueux que d'autres. A titre d'exemple, on a représenté en figure 13 un flanc moins rugueux 154 et un flanc davantage rugueux 156. Les aspérités du flanc davantage rugueux 156 sont adaptées pour former des sites de croissance de boîtes quantiques tandis qu'une couche active comprenant des puits quantiques peut être formée sur le flanc moins rugueux 154.

Dans le cas d'un élément semiconducteur correspondant à une pyramide 152 composé principalement de GaN, la couche de germination 19 peut favoriser la croissance du GaN avec la polarité Ga. Selon un mode de réalisation du procédé de fabrication du dispositif 150, le rapport V/III est faible, par exemple inférieur à 50. Ceci entraîne la formation de pyramides comprenant des flancs lisses et des flancs rugueux. Pour augmenter la rugosité des flancs rugueux, après la croissance des pyramides, les flux des précurseurs des éléments V et III peuvent être interrompus et le réacteur de croissance peut être mis sous une pression de dihydrogène, par exemple à 0,8 bar pendant 10 minutes. Ceci entraîne une augmentation plus forte de la rugosité du flanc 156 par rapport au flanc 154.

Des modes de réalisation particuliers ont été décrits. Diverses variantes et modifications apparaîtront à l'homme de l'art. En particulier, bien qu'on ait représenté sur les figures des modes de réalisation dans lesquels les fils, recouverts d'une première électrode, sont formés sur une première face d'un support tandis qu'une deuxième électrode est formée sur une deuxième face du support, opposée à la première face, il est clair que la deuxième électrode peut être prévue du côté de la première face. En outre, bien que les modes de réalisation plus détaillés décrits précédemment concernent des composés III-V, ce qui a été décrit peut également être mis en oeuvre pour la fabrication de composés II-VI.

Divers modes de réalisation avec diverses variantes ont été décrits ci-dessus. On note que l'homme de l'art pourra combiner divers éléments de ces divers modes de réalisation et variantes sans faire preuve d'activité inventive. En particulier, les formes particulières des portions 32 à paroi rugueuse des figures 10 à 12 peuvent être mises en oeuvre avec certains des modes de réalisation de dispositifs optoélectroniques 70, 80, 90, 100 et 110 décrits en relation avec les figures 5 à 9. L'invention est définie par les revendications attenantes.

## Revendications

1. Dispositif optoélectronique (30) comprenant des éléments semiconducteurs tridimensionnels (20 ; 152) majoritairement en un premier composé choisi parmi le groupe comprenant les composés III-V, les composés II-VI et les composés IV, chaque élément semiconducteur délimitant, éventuellement avec des portions isolantes recouvrant partiellement ledit élément semiconducteur, au moins une première surface (34) comprenant des facettes jointives inclinées les unes par rapport aux autres, le dispositif optoélectronique comprenant des boîtes quantiques (60) à au moins certaines des jointures (42) entre les facettes, les boîtes quantiques étant majoritairement en un mélange du premier composé et d'un élément supplémentaire et étant adaptées à l'émission ou à la réception d'un premier rayonnement électromagnétique à une première longueur d'onde, le dispositif comprenant, en outre, une couche active (62 ; 76) comprenant au moins un puits quantique unique ou des puits quantiques multiples et adaptée à l'émission ou à la réception d'un deuxième rayonnement électromagnétique à une deuxième longueur d'onde différente de la première longueur d'onde, la couche active recouvrant les boîtes quantiques.

2. Dispositif optoélectronique (30) selon la revendication 1, chaque élément semiconducteur comprenant une deuxième surface (74), distincte de la première surface (34), ladite couche active (76) recouvrant la deuxième surface.

3. Dispositif optoélectronique selon la revendication 1 ou 2, dans lequel chaque boîte quantique (60) est majoritairement en un composé InₓAl_{y}Ga_{1-x-y}N où 0≤x≤1, 0≤y≤1 et 1-x-y>0.

4. Dispositif optoélectronique selon l'une quelconque des revendications 1 à 3, dans lequel les éléments semiconducteurs (20) sont des nanofils, des microfils et/ou des structures pyramidales de taille nanométrique ou micrométrique.

5. Dispositif optoélectronique selon l'une quelconque des revendications 1 à 4, dans lequel les éléments semiconducteurs ont une forme allongée selon une direction privilégiée, et dans lequel la distance, mesurée perpendiculairement à la direction privilégiée, entre deux jointures (42) de paires de jointures adjacentes est supérieure à 5 nm.

6. Dispositif optoélectronique selon la revendication 5, dans lequel la distance, mesurée parallèlement à la direction privilégie, entre deux jointures (42) adjacentes est inférieure à 1 µm.

7. Dispositif optoélectronique selon la revendication 5, dans lequel la densité de jointures (42) est supérieure à 10⁸ jointures/cm².

8. Procédé de fabrication d'un dispositif optoélectronique (30) comprenant les étapes suivantes :
formation d'éléments semiconducteurs tridimensionnels (20 ; 152) majoritairement en un premier composé choisi parmi le groupe comprenant les composés III-V, les composés II-VI et les composés IV, chaque élément semiconducteur délimitant, éventuellement avec des portions isolantes recouvrant partiellement ledit élément semiconducteur, au moins une première surface (34) comprenant des facettes jointives inclinées les unes par rapport aux autres ;
formation de boîtes quantiques (60) à au moins certaines des jointures (42) entre les facettes, les boîtes quantiques étant majoritairement en un mélange du premier composé et d'un élément supplémentaire et étant adaptées à l'émission ou à la réception d'un premier rayonnement électromagnétique à une première longueur d'onde ; et
formation d'une couche active (62 ; 76) comprenant au moins un puits quantique unique ou des puits quantiques multiples et adaptée à l'émission ou à la réception d'un deuxième rayonnement électromagnétique à une deuxième longueur d'onde différente de la première longueur d'onde, la couche active (62; 76) recouvrant les boîtes quantiques (60).

9. Procédé selon la revendication 8, comprenant la formation des éléments semiconducteurs (20) et la gravure partielle des éléments semiconducteurs pour former la première surface (34).

10. Procédé selon la revendication 8, dans lequel la première surface est formée simultanément à la croissance des éléments semiconducteurs (20).

## Patentansprüche

1. Optoelektronische Vorrichtung (30) mit dreidimensionalen Halbleiterelementen (20; 152), die überwiegend aus einer ersten Verbindung hergestellt sind, die aus der Gruppe ausgewählt ist, die III-V-Verbindungen, II-VI-Verbindungen und IV-Verbindungen aufweist, wobei jedes Halbleiterelement optional mit isolierenden Teilen, die das Halbleiterelement teilweise bedecken, wenigstens eine erste Oberfläche (34) begrenzt, die zusammenhängende Facetten aufweist, die zueinander abgewinkelt sind, wobei die optoelektronische Vorrichtung Quantenpunkte (60) an wenigstens einigen der Nähte bzw. Übergänge (42) zwischen den Facetten aufweist, wobei die Quantenpunkte überwiegend aus einer Mischung der ersten Verbindung und eines zusätzlichen Elements hergestellt sind und in der Lage sind, eine erste elektromagnetische Strahlung mit einer ersten Wellenlänge zu emittieren oder zu empfangen, wobei die Vorrichtung ferner eine aktive Schicht (62; 76) aufweist, die wenigstens einen einzelnen Quantentopf oder mehrere Quantentöpfe aufweist und in der Lage ist, eine zweite elektromagnetische Strahlung mit einer zweiten Wellenlänge, die sich von der ersten Wellenlänge unterscheidet, zu emittieren oder zu empfangen, wobei die aktive Schicht die Quantenpunkte bedeckt.

2. Optoelektronische Vorrichtung (30) nach Anspruch 1, wobei jedes Halbleiterelement eine zweite Oberfläche (74) aufweist, die sich von der ersten Oberfläche (34) unterscheidet, wobei die aktive Schicht (76) die zweite Oberfläche bedeckt.

3. Optoelektronische Vorrichtung nach Anspruch 1 oder 2, wobei jeder Quantenpunkt (60) überwiegend aus einer InₓAl_{y}Ga_{1-x-y}N-Verbindung hergestellt ist, wobei 0≤x≤1, 0≤y≤1 und 1-x-y> 0 ist.

4. Optoelektronische Vorrichtung nach einem der Ansprüche 1 bis 3, wobei die Halbleiterelemente (20) Nanodrähte, Mikrodrähte und/oder pyramidenförmige Strukturen im Nano- oder Mikrometerbereich sind.

5. Optoelektronische Vorrichtung nach einem der Ansprüche 1 bis 4, wobei die Halbleiterelemente eine Form aufweisen, die entlang einer bevorzugten Richtung verlängert ist, und wobei der Abstand, gemessen senkrecht zur bevorzugten Richtung, zwischen zwei Übergängen (42) von Paaren benachbarter Übergänge größer als 5 nm ist.

6. Optoelektronische Vorrichtung nach Anspruch 5, wobei der Abstand, gemessen parallel zur bevorzugten Richtung, zwischen zwei benachbarten Übergängen (42) kleiner als 1 µm ist.

7. Optoelektronische Vorrichtung nach Anspruch 5, wobei die Dichte der Übergänge (42) größer als 10⁸ Übergänge/cm² ist.

8. Verfahren zur Herstellung einer optoelektronischen Vorrichtung (30), die folgende Schritte aufweist:
Ausbilden von dreidimensionalen Halbleiterelementen (20; 152), die überwiegend aus einer ersten Verbindung hergestellt sind, die aus der Gruppe ausgewählt ist, die III-V-Verbindungen, II-VI-Verbindungen und IV-Verbindungen aufweist, wobei jedes Halbleiterelement optional mit isolierenden Teilen, die das Halbleiterelement teilweise bedecken, wenigstens eine erste Oberfläche (34) begrenzt, die zusammenhängende Facetten aufweist, die zueinander abgewinkelt sind;
Ausbilden von Quantenpunkten (60) an wenigstens einigen der Übergänge (42) zwischen den Facetten, wobei die Quantenpunkte überwiegend aus einer Mischung der ersten Verbindung und eines zusätzlichen Elements hergestellt sind und in der Lage sind, eine erste elektromagnetische Strahlung mit einer ersten Wellenlänge zu emittieren oder zu empfangen; und
Ausbilden einer aktiven Schicht (62; 76), die wenigstens einen einzelnen Quantentopf oder mehrere Quantentöpfe aufweist und in der Lage ist, eine zweite elektromagnetische Strahlung mit einer zweiten Wellenlänge, die sich von der ersten Wellenlänge unterscheidet, zu emittieren oder zu empfangen, wobei die aktive Schicht (62; 76) die Quantenpunkte (60) bedeckt.

9. Verfahren nach Anspruch 8, das das Ausbilden von Halbleiterelementen (20) und das teilweise Ätzen der Halbleiterelemente zum Ausbilden der ersten Oberfläche (34) aufweist.

10. Verfahren nach Anspruch 8, wobei die erste Oberfläche gleichzeitig mit dem Aufwachsen der Halbleiterelemente (20) ausgebildet wird.

## Claims

1. An optoelectronic device (30) comprising three-dimensional semiconductor elements (20; 152) predominantly made of a first compound selected from the group comprising III-V compounds, II-VI compounds, and IV compounds, each semiconductor element delimiting, optionally with insulating portions partially covering said semiconductor element, at least a first surface (34) comprising contiguous facets angled with respect to one another, the optoelectronic device comprising quantum dots (60) at at least some of the seams (42) between facets, the quantum dots being predominantly made of a mixture of the first compound and of an additional element and being capable of emitting or of receiving a first electromagnetic radiation at a first wavelength, the device further comprising an active layer (62; 76) comprising at least a single quantum well or multiple quantum wells and capable of emitting or of receiving a second electromagnetic radiation at a second wavelength different from the first wavelength, the active layer covering the quantum dots.

2. The optoelectronic device (30) of claim 1, each semiconductor element comprising a second surface (74), distinct from the first surface (34), said active layer (76) covering the second surface.

3. The optoelectronic device of claim 1 or 2, wherein each quantum dot (60) is predominantly made of a InₓAl_{y}Ga_{1-x-y}N compound, where 0 ≤ x ≤ 1, 0 ≤ y ≤ 1 and 1-x-y > 0.

4. The optoelectronic device of any of claims 1 to 3, wherein the semiconductor elements (20) are nanowires, microwires, and/or nanometer- or micrometer-range pyramidal structures.

5. The optoelectronic device of any of claims 1 to 4, wherein the semiconductor elements have a shape elongated along a preferred direction, and wherein the distance, measured perpendicularly to the preferred direction, between two seams (42) of pairs of adjacent seams is greater than 5 nm.

6. The optoelectronic device of claim 5, wherein the distance, measured parallel to the preferred direction, between two adjacent seams (42) is smaller than 1 µm.

7. The optoelectronic device of claim 5, wherein the density of seams (42) is greater than 10⁸ seams/cm².

8. A method of manufacturing an optoelectronic device (30), comprising the steps of:
forming three-dimensional semiconductor elements (20; 152) predominantly made of a first compound selected from the group comprising III-V compounds, II-VI compounds, and IV compounds, each semiconductor element delimiting, optionally with insulating portions partially covering said semiconductor element, at least a first surface (34) comprising contiguous facets angled with respect to one another;
forming quantum dots (60) at at least some of the seams (42) between facets, the quantum dots being predominantly made of a mixture of the first compound and of an additional element and being capable of emitting or of receiving a first electromagnetic radiation at a first wavelength; and
forming an active layer (62; 76) comprising at least a single quantum well or multiple quantum wells and capable of emitting or of receiving a second electromagnetic radiation at a second wavelength different from the first wavelength, the active layer (62; 76) covering the quantum dots (60).

9. The method of claim 8, comprising forming semiconductor elements (20) and partially etching the semiconductor elements to form the first surface (34).

10. The method of claim 8, wherein the first surface is formed simultaneously to the growth of the semiconductor elements (20) .
